# EUROPÄISCHE PATENTSCHRIFT

(11) **EP 3 262 698 B1**
(45) Veröffentlichungstag und Bekanntmachung des Hinweises auf die Patenterteilung: **19.05.2021**
(21) Anmeldenummer: 16706991.3
(22) Anmeldetag: 11.02.2016
(51) Int. Cl.: H01L 41/083, H01L 41/277, H01L 41/332, H01L 41/338, H01L 41/053, H01L 41/23, H01L 41/293, H01L 41/273

(54) **VERFAHREN ZUR HERSTELLUNG VON VIELSCHICHTBAUELEMENTEN UND VIELSCHICHTBAUELEMENT, INSBESONDERE PIEZOAKTOREN**
METHOD FOR MANUFACTURING MULTILAYER COMPONENTS, AND MULTILAYER COMPONENT
PROCÉDÉ DE FABRICATION DE COMPOSANTS MULTICOUCHES ET COMPOSANT MULTICOUCHE

(30) Priorität: 25.02.2015 DE 102015102713
(43) Veröffentlichungstag der Anmeldung: 03.01.2018
(73) Patentinhaber: TDK Electronics AG, 81671 München (DE)
(72) Erfinder: OTTLINGER, Marion, 8530 Deutschlandsberg (AT); JAGUST, Ivan, 10000 Zagreb (HR)
(74) Vertreter: Epping - Hermann - Fischer
(86) Internationale Anmeldenummer: PCT/EP2016/052927
(87) Internationale Veröffentlichungsnummer: WO 2016/134978

(56) Entgegenhaltungen:
- EP-A1- 1 942 533
- DE-A1-102012 101 351
- DE-A1-102012 105 287

## Beschreibung

Die vorliegende Anmeldung betrifft ein Verfahren zur Herstellung von elektrischen Vielschichtbauelementen sowie ein Vielschichtbauelement. Beispielsweise ist das Vielschichtbauelement als Piezoaktor ausgebildet der zum Betätigen eines Einspritzventils in einem Kraftfahrzeug eingesetzt werden kann.

Aus der Druckschrift DE 102012105287 A1 ist ein Verfahren zur Herstellung eines solchen Vielschichtbauelements bekannt, bei dem eine Isolationszone unter Nutzung des Kapillareffekts mit Isolationsmaterial befüllt wird.

DE 102012101351 A1 beschreibt die Herstellung eines piezoelektrischen Vielschichtbauelements, wobei in einem Stapel zunächst Innenelektroden elektrochemisch zurückgeätzt werden. Die so entstandenen Gräben werden entweder galvanisch mit einem leitenden Material oder mit einem isolierenden Material befüllt.

Es ist eine zu lösende Aufgabe, ein verbessertes Verfahren zur Herstellung von Vielschichtbauelementen und ein Vielschichtbauelement mit verbesserten Eigenschaften anzugeben.

Diese Aufgabe wird durch ein Verfahren gemäß dem Patentanspruch 1 sowie durch ein Vielschichtbauelement gemäß dem zweiten unabhängigen Patentanspruch gelöst.

Es wird ein Verfahren zur Herstellung von Vielschichtbauelemente angegeben, bei dem zunächst ein Körper hergestellt wird der übereinander gestapelte elektrisch leitfähige Schichten und dielektrische Schichten aufweist, wobei der Körper zumindest eine Kavität aufweist. In einem weiteren Verfahrensschritt wird die Kavität zumindest teilweise mit einem Isolationsmaterial unter Nutzung von Kapillarkräften befüllt. In einem weiteren Verfahrensschritt wird der Körper in zumindest zwei Grundkörper vereinzelt. Der Schritt der Vereinzelung wird erst nach dem zumindest teilweisen Befüllen der Kavitäten durchgeführt. Ferner wird eine Passivierungsschicht auf Oberflächen der vereinzelten Grundkörper aufgebracht, wobei die Passivierungsschicht ein von dem Isolationsmaterial verschiedenes Material aufweist.

Die mit diesem Verfahren hergestellten Vielschichtbauelemente weisen dementsprechend einen Grundkörper auf, der übereinander gestapelte elektrisch leitfähige Schichten und dielektrische Schichten sowie zumindest teilweise mit Isolationsmaterial befüllte Kavitäten aufweist. Ferner weisen die Vielschichtbauelemente eine Passivierungsschicht auf, die Oberflächen des Grundkörpers bedeckt und deren Material sich vom Isolationsmaterial unterscheidet.

Bei dem aus dem Stand der Technik bekannten Herstellungsverfahren wurde der Körper zunächst in Vielschichtbauelemente vereinzelt und erst anschließend wurden die Kavitäten mit Isolationsmaterial befüllt.

Diese Vorgehensweise hat sich jedoch als nachteilig erwiesen. Bei der Vereinzelung wird der Körper gesägt. Dieses Sägen wird in einem Trennwasser durchgeführt, dem bestimmte Zusatzstoffe zugegeben sind. Wird nunmehr der Schritt der Vereinzelung vor dem Befüllen der Kavitäten durchgeführt, so dringt bei der Vereinzelung das Trennwasser in die Kavitäten ein. Insbesondere die Zusatzstoffe verbleiben in den Kavitäten und können nachträglich kaum mehr aus diesen herausgelöst werden. Die Zusatzstoffe sorgen in dem fertiggestellten Vielschichtbauelement für eine Verschlechterung der elektrischen Eigenschaften dieses Vielschichtbauelements.

Wird nunmehr wie erfindungsgemäß vorgeschlagen, die Kavität vor der Vereinzelung mit Isolationsmaterial befüllt, so wird verhindert, dass bei der Vereinzelung Trennwasser in die Kavitäten eindringen kann. Dementsprechend können auch die in dem Trennwasser enthaltenen Zusatzstoffe sich nicht mehr in dem Grundkörper in den Kavitäten ablagern und verschlechtern dementsprechend nicht mehr die elektrischen Eigenschaften des Vielschichtbauelements. Das hier beschriebene Verfahren führt somit zu Vielschichtbauelementen mit verbesserten elektrischen Eigenschaften.

Durch die Vereinzelung des Körpers in Grundkörper können ferner zahlreiche scharfe Kanten entstehen, die sich aus der Vereinzelung durch Sägen ergeben. Diese Kanten sind sehr anfällig gegen mechanische Beschädigungen. Es ist daher auch grundsätzlich vorzuziehen, möglichst viele Schritte des Herstellungsverfahrens an dem Körper, in dem zahlreiche Vielschichtbauelemente zusammengefasst sind, durchzuführen, um die Gefahr der Beschädigung an den scharfen Kanten möglichst gering zu halten.

Außerdem ist der Aufwand zur Handhabung eines solchen Körpers erheblich geringer als dies für vereinzelte Vielschichtbauelemente der Fall ist, die eine Einzelteilhandhabung erfordern würden.

Ein weiterer Vorteil des Verfahrens liegt darin, dass dieses es erlaubt, das Material des Isolationsmaterials frei zu wählen. Das Verfahren kann dafür sorgen, dass das Isolationsmaterials lediglich in den befüllten Kavitäten angeordnet wird.

Gemäß dem hier beschriebenen Verfahren werden das Isolationsmaterial und die Passivierungsschicht in zwei voneinander getrennten Verfahrensschritten aufgebracht. Dementsprechend ist es nicht erforderlich für das Isolationsmaterial und das Material der Passivierungsschicht das gleiche Material zu verwenden. Vielmehr erlaubt es das erfindungsgemäße Verfahren für jede der beiden Schichten ein Material auszuwählen, das an die jeweiligen Anforderungen angepasst ist.

Das Isolationsmaterial sollte dabei so gewählt werden, dass es sehr gute Fließeigenschaften aufweist, da es in sehr dünne Kavitäten eindringen soll, deren Ausdehnung im Bereich von wenigen Mikrometern liegen kann. Hierzu eignet sich beispielsweise ein weiches, dünnflüssiges Elastomer. Das Isolationsmaterial sollte keine Lösungsmittel und keine anorganischen Füllstoffe enthalten. Ferner sollte das Material eine hohe elektrische Durchschlagsfestigkeit aufweisen.

Die Passivierungsschicht, die auf aktiven Seitenflächen eines Grundkörpers aufgetragen sind, sollte sich insbesondere durch eine hohe elektrische Durchschlagsfestigkeit auszeichnen, da die Passivierung eine Beschädigung und/oder einen Ausfall des Vielschichtbauelements verhindern muss.

Das Material der Passivierungsschicht sollte vorzugsweise eine eingeschränkte Fließfähigkeit aufweisen, um so die Einhaltung der geometrischen Anforderungen an das Vielschichtbauelement in engen Toleranzen zu ermöglichen.

Außerdem sollte dieses Material eine definierte Mindesthärte aufweisen, um die Transportfähigkeit und das Handling des Vielschichtbauelementes zu vereinfachen.

Die Anforderungen an das Material der Passivierungsschicht und an das Isolationsmaterial sind somit zum Teil gegenläufig, insbesondere hinsichtlich der Fließeigenschaften des jeweiligen Materials. Daher werden für das Isolationsmaterial und das Material der Passivierungsschicht unterschiedliche Materialien verwendet.

In dem Körper können die elektrisch leitfähigen Schichten und dielektrische Schichten in einer Stapelrichtung übereinander gestapelt sein, wobei sich die Kavitäten in einer Richtung senkrecht zur Stapelrichtung erstrecken. Insbesondere können die Kavitäten an Außenflächen des Körpers angeordnet sein. Die Kavitäten können entlang der elektrisch leitfähigen Schichten verlaufen und ein Ende der elektrisch leitfähigen Schichten bedecken.

Vor dem Befüllen der Kavitäten mit dem Isolationsmaterial kann auf dem Körper auf einer ersten und einer zweiten Außenfläche für jedes Vielschichtbauelement je eine Außenkontaktierung aufgebracht werden, die die Kavität teilweise bedeckt und die sich in Stapelrichtung erstreckt. Diese Außenkontaktierungen können zur elektrischen Kontaktierung der elektrisch leitfähigen Schichten dienen.

Zwischen zwei nebeneinander auf dem Körper angeordneten Außenkontaktierungen kann jeweils ein Spalt verbleiben, wobei im Verfahrensschritt "Befüllen der Kavität mit Isoliermaterial" in Stapelrichtung auf jedem zweiten Spalt Isolationsmaterial aufgebracht werden kann.

Durch das gezielte Aufbringen des Isolationsmaterials auf jedem zweiten Spalt kann ein schnelles Einziehen des Isolationsmaterials in die Kavitäten unter Nutzung der Kapillarkräfte ermöglicht werden. Das Isolationsmaterial kann dabei aus den mit Isolationsmaterial gefüllten Spalten in die jeweiligen Kavitäten hineingezogen werden. Gleichzeitig kann Luft aus den Kavitäten in die Spalte entweichen, die nicht mit Isolationsmaterial befüllt sind. Auf diese Weise wird das Zurückbleiben von Luftblasen in den Kavitäten vermieden. Es kann also ein gleichmäßiges Befüllen der Kavitäten ermöglicht werden. Insbesondere kann diese Art der Befüllung zu einer schnellen Befüllzeit führen. Der entsprechende Verfahrensschritt kann in weniger als 20 Minuten durchgeführt werden. Der Schritt kann dabei für jede der beiden Außenseiten getrennt durchgeführt werden, wobei jeweils eine Prozessschrittdauer von weniger als 20 Minuten anfällt.

Ferner kann dabei die Außenkontaktierung als Barriere ausgenutzt werden. Sie kann insbesondere verhindern, dass das Isolationsmaterial in Bereiche des Vielschichtbauelements fließt, in denen es unerwünscht ist. Die Außenkontaktierung kann dabei auch verhindern, dass das Isolationsmaterial auf die gegenüberliegende Seite des Grundkörpers gelangt.

Das Isolationsmaterial kann ein Silikonelastomer sein, das frei von Füllstoffen ist. Insbesondere kann das Isolationsmaterial frei von anorganischen Füllstoffen sein. Dieses Isolationsmaterial erfüllt besonders gut die oben genannten Anforderungen an das Isolationsmaterial und zeichnet sich durch seine Dünnflüssigkeit aus.

Die Passivierungsschicht kann ein Silikonelastomer aufweisen, das einen anorganischen Füllstoff aufweist. Bei dem Füllstoff kann es sich um Siliziumoxid handeln. Der anorganische Füllstoff kann einen Anteil an dem Material der Passivierungsschicht von zwischen 30 und 70 Gewichts-%, vorzugsweise zwischen 40 und 60 Gewichts-%, haben. Besteht die Passivierungsschicht aus dem Silikonelastomer mit anorganischem Füllstoff, so zeichnet sie sich durch eine Dickflüssigkeit aus, die es ermöglicht die oben genannten Anforderungen sehr gut zu erfüllen. Außerdem zeichnet sie sich durch eine hohe elektrische Durchschlagsfestigkeit aus. Bei dem Füllstoff kann es sich um Siliziumoxid handeln.

Die Kavität kann an eine elektrisch leitfähige Schicht angrenzen und dabei ein Ende der elektrisch leitfähigen Schicht bedecken. Dementsprechend kann die Kavität, die mit Isolationsmaterial gefüllt ist, zur Isolierung der jeweiligen elektrisch leitfähigen Schicht gegenüber einer Außenkontaktierung dienen.

Ein weiterer Aspekt der vorliegenden Erfindung betrifft ein Vielschichtbauelement. Dabei kann es sich insbesondere um ein Vielschichtbauelement handeln, das mit dem oben beschriebenen Verfahren hergestellt ist. Dementsprechend kann jedes strukturelle und/oder funktionelle Merkmal, das im Zusammenhang mit dem Verfahren beschrieben wurde, auch auf das Vielschichtbauelement zutreffen und umgekehrt.

Es wird ein Vielschichtbauelement vorgeschlagen, das einen Grundkörper mit übereinander angeordnete elektrisch leitfähige Schichten und dielektrische Schichten aufweist, wobei der Grundkörper ferner eine Kavität aufweist, die zumindest teilweise mit einem Isolationsmaterial befüllt ist, und wobei das Vielschichtbauelement eine Passivierungsschicht aufweist, die den Grundkörper zumindest teilweise bedeckt und die ein von dem Isolationsmaterial verschiedenes Material aufweist.

Wie bereits im Zusammenhang mit dem Verfahren erläutert, ist es vorteilhaft für die Passivierungsschicht ein Material zu wählen, das sich von dem Isolationsmaterial unterscheidet, da an diese beiden Materialien unterschiedliche, zum Teil sogar gegensätzliche, Anforderungen gestellt sind.

Ferner kann das Vielschichtbauelement eine Außenkontaktierung aufweisen, die auf einer Außenfläche des Vielschichtbauelements angeordnet ist, wobei das Isolationsmaterial zwischen der elektrisch leitfähigen Schicht und der Außenkontaktierung angeordnet ist, und wobei die Passivierungsschicht Oberflächen des Vielschichtbauelements bedeckt, die frei von der Außenkontaktierung sind. Dementsprechend kann die Oberfläche des Grundkörpers an jeder Stelle entweder von der Passivierungsschicht oder der Außenkontaktierung bedeckt sein.

Die Passivierungsschicht kann ein Silikonelastomer aufweisen, das einen anorganischen Füllstoff aufweist, und das Isolationsmaterial kann ein Silikonelastomer sein, der frei von Füllstoffen ist.

Im Folgenden werden das Vielschichtbauelement und das Herstellungsverfahren anhand von schematischen und nicht maßstabsgetreuen Figuren näher erläutert.
- Figur 1: zeigt eine perspektivische Ansicht eines Körpers, aus dem Vielschichtbauelemente gefertigt werden, zu einem ersten Verfahrenszeitpunkt.
- Figur 2: zeigt einen Querschnitt durch den Körper zu einem späteren Verfahrenszeitpunkt.
- Figur 3: zeigt den Körper in einem noch späteren Verfahrensschritt.
- Figur 4: zeigt einen zu dem in Figur 3 gezeigten alternativen Verfahrensschritt.
- Figur 5: zeigt ein fertiggestelltes Vielschichtbauelement.
- Figur 6: zeigt ein Diagramm, in dem eine Ausfallwahrscheinlichkeit in Folge von Durchbrüchen für Vielschichtbauelemente mit verschiedenen Materialkombinationen betrachtet wird.

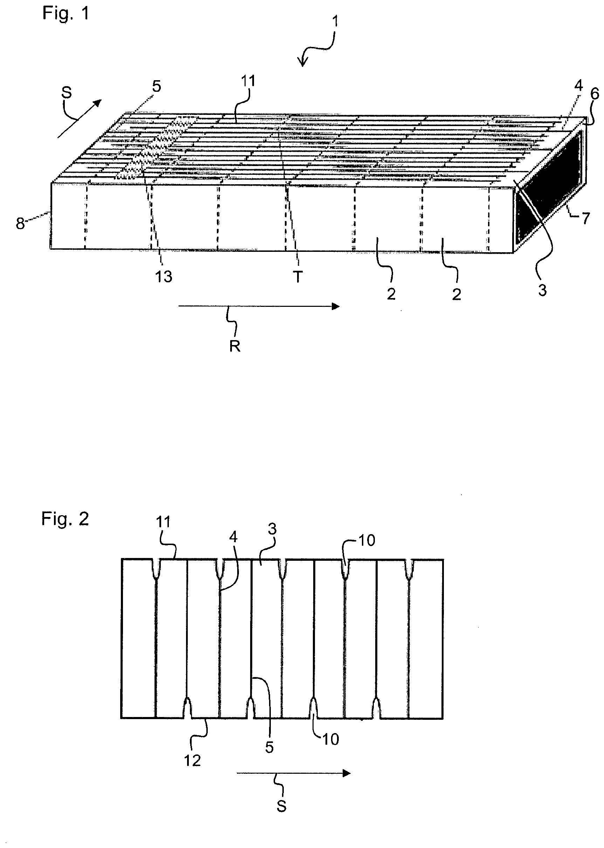

Im Folgenden wird ein Verfahren zur Herstellung von Vielschichtbauelementen beschrieben. Figur 1 zeigt einen Körper 1, der in einem späteren Verfahrensschritt zu einer Vielzahl von Vielschichtbauelementen vereinzelt werden wird.

Der in Figur 1 gezeigte Körper 1 ist als Riegel ausgebildet und kann später entlang der eingezeichneten Trennlinien T in mehrere Grundkörper 2 für Vielschichtbauelemente zertrennt werden. Beispielsweise sind die Vielschichtbauelemente als Piezoaktoren ausgebildet.

Der Körper 1 und damit auch die später daraus gebildeten Grundkörper 2 weisen dielektrische Schichten 3 auf, die entlang einer Stapelrichtung S übereinander angeordnet sind. Zwischen den dielektrischen Schichten 3 sind erste und zweite leitfähige Schichten 4, 5 angeordnet. Die dielektrischen Schichten 3 enthalten beispielsweise ein Keramikmaterial.

Vorzugsweise sind die dielektrischen Schichten 3 als piezoelektrische Schichten ausgebildet, insbesondere können sie ein piezokeramisches Material aufweisen.

Bei dem in Figur 1 gezeigten Verfahrenszustand ist der Körper 1 bereits gesintert. Besonders bevorzugt ist der Körper 1 ein monolithischer Sinterkörper, so dass die leitfähigen Schichten 4, 5 zusammen mit den dielektrischen Schichten 3 gesintert sind. In einem alternativen Ausführungsbeispiel liegt der abgebildete Körper 1 im Grünzustand vor.

Die ersten leitfähigen Schichten 4 sind abwechselnd mit den zweiten leitfähigen Schichten 5 entlang der Stapelrichtung S angeordnet. Die ersten leitfähigen Schichten 4 reichen bis zu einer dritten Seitenfläche 6, während die zweiten leitfähigen Schichten 5 von der dritten Seitenfläche 6 beabstandet sind. Auf der dritten Seitenfläche 6 ist eine erste Hilfselektrode 7 angeordnet, die mit den ersten leitfähigen Schichten 4 kontaktiert ist. Die zweiten leitfähigen Schichten 5 reichen bis zur vierten Seitenfläche 8, während die ersten leitfähigen Schichten 4 von der vierten Seitenfläche 8 beabstandet sind. Auf der vierten Seitenfläche 8 ist eine zweite Hilfselektrode angeordnet, die mit den zweiten leitfähigen Schichten 5 elektrisch kontaktiert ist.

Die leitfähigen Schichten 4, 5 enthalten ein Metall. Besonders bevorzugt enthalten die leitfähigen Schichten 4, 5 Kupfer oder bestehen aus Kupfer. In weiteren Ausführungsformen können die leitfähigen Schichten 4, 5 beispielsweise Silber oder Silber-Palladium enthalten.

Ferner ist in Figur 1 eine Außenkontaktierung 13 für einen der Grundkörper 2 angedeutet, die zu diesem Verfahrenszeitpunkt jedoch noch nicht auf dem Körper 1 aufgebracht ist.

In einem nächsten Verfahrensschritt wird zunächst Material der leitfähigen Schichten 4, 5 abgetragen, so dass Kavitäten 10 entstehen, die sich in einer Richtung R senkrecht zur Stapelrichtung S erstrecken. Figur 2 zeigt den Körper 1 nach der Durchführung dieses Verfahrensschrittes in einem Querschnitt entlang einer Trennlinie T.

Der Materialabtrag wird beispielsweise durch einen elektrisch gesteuerten Ätzprozess durchgeführt. Dabei wird selektiv über die erste Hilfselektrode 7 an die ersten leitfähigen Schichten 4, bzw. über die zweite Hilfselektrode an die zweiten elektrisch leitfähigen Schichten 5, ein Strom angelegt und die Schichten werden in eine chemische Ätzlösung, beispielsweise Na₂S₂O₈, eingetaucht, so dass sich die Elektroden, beispielsweise Cu-Elektroden, aus den jeweiligen leitfähigen Schichten 4, 5 herauslösen. Der Ätzprozess wird an dem Körper 1 durchgeführt, bevor dieser in einem späteren Verfahrensschritt vereinzelt wird.

Es werden bei dem Ätzprozess Bereiche der ersten leitfähigen Schichten 4 auf einer ersten Seitenfläche 11 des Körpers 1 entfernt, so dass hier Kavitäten 10 entstehen. Ferner werden bei dem selektiven Ätzprozess Bereiche der zweiten leitfähigen Schichten 5 auf einer zweiten Seitenfläche 12 des Körpers 1 entfernt, so dass hier Kavitäten 10 entstehen. Die Kavitäten 10 können in Stapelrichtung S eine Breite zwischen 3 µm und 5 µm aufweisen.

In einem weiteren Verfahrensschritt werden erste Außenkontaktierungen 13 auf der ersten Seitenfläche 11 des Körpers 1 und zweite Außenkontaktierungen auf der zweiten Seitenfläche 12 des Körpers 1 angeordnet. Die zweite Seitenfläche 12 liegt der ersten Seitenfläche 11 gegenüber. Die Außenkontaktierungen 13 werden derart aufgebracht, dass jeder der Grundkörper 2 in die der Körper 1 später vereinzelt wird jeweils eine erste Außenkontaktierung 13 auf der ersten Seitenfläche 11 und eine zweite Außenkontaktierung auf der zweiten Seitenfläche 12 aufweist. Die Außenkontaktierungen 13 erstrecken sich dabei in Stapelrichtung S auf den jeweiligen Grundkörpern 2. Zwischen zwei benachbarten Außenkontaktierungen 13 verbleibt jeweils ein Spalt 15, der frei von der Außenkontaktierung 13 ist.

Dementsprechend wechseln sich in der Richtung R senkrecht zur Stapelrichtung S die Außenkontaktierungen 13 und die Spalte 15 ab.

Jede Außenkontaktierung 13 weist eine gesinterte Grundfläche auf, die insbesondere aus einer gesinterten Silberschicht bestehen kann. Ferner weist die Außenkontaktierung 13 ein Kontaktelement auf, das mit der gesinterten Grundmetallisierung kontaktiert ist.

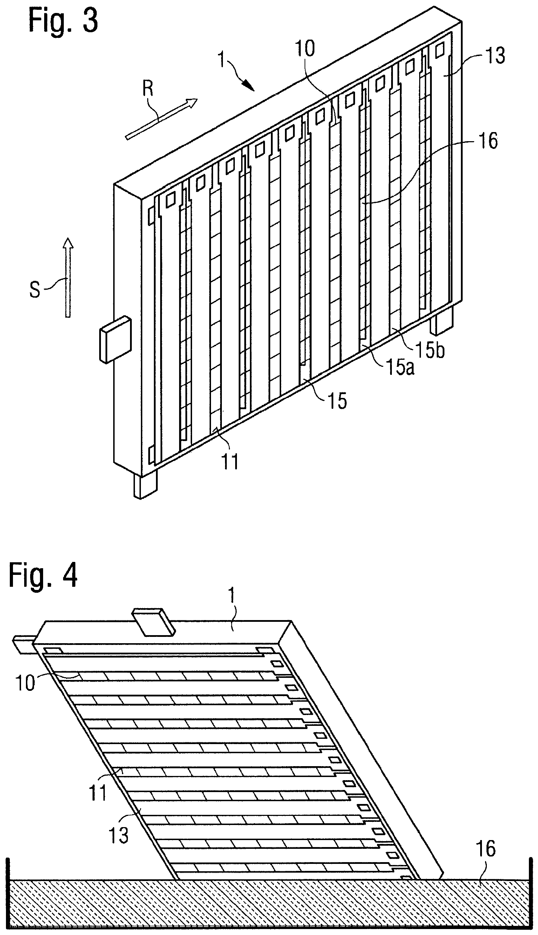

Figur 3 zeigt den Körper in einem späteren Verfahrensschritt, bei dem die Kavitäten 10 auf der ersten Seitenfläche 11 des Körpers 1 befüllt werden. Der Körper 1 wird auf die zweite Seitenfläche 12 gelegt, so dass die erste Seitenfläche 11 von einem Untergrund weg weist.

Auf der ersten Seitenfläche 11 wird in der Richtung R senkrecht zur Stapelrichtung S jeder zweite Spalt 15 mit einem Isolationsmaterial 16 bedeckt. Bei dem Isolationsmaterial 16 handelt es sich um ein Silikonelastomer, das frei von anorganischen Füllstoffen ist.

Durch Kapillarkräfte wird nunmehr das Isolationsmaterial 16 in die Kavitäten 10 eingezogen. Dabei dringt das Isolationsmaterial 16 aus einem ersten Spalt 15a in die Kavität 10 ein, wobei gleichzeitig in einem zweiten Spalt 15b, der zu dem ersten Spalt 15a benachbart ist und der nicht mit Isolationsmaterial 16 befüllt ist, Luft, die durch das einbringende Isolationsmaterial 16 verdrängt wird, entweichen kann. Auf diese Weise wird verhindert, dass in den Kavitäten 10 Luftblasen verbleiben. Ist dieser Prozess der Befüllung der Kavitäten 10 des Körpers 1 abgeschlossen, so ist jede Kavität 10 auf der ersten Seitenfläche 11 zumindest teilweise mit Isolationsmaterial 16 befüllt. Insbesondere kann jede Kavität 10 vollständig mit Isolationsmaterial 16 befüllt sein.

Anschließend wird der Körper 1 gewendet, so dass er nunmehr mit der ersten Seitenfläche 11 auf dem Untergrund aufliegt. Der in Figur 3 gezeigte Prozessschritt wird nunmehr für die zweite Seitenfläche 12 wiederholt. Wiederum wird Isolationsmaterial 16 auf jeden zweiten Spalt 15 in einer Richtung R senkrecht zur Stapelrichtung S auf der zweiten Seitenfläche 12 aufgebracht. Durch Kapillarkräfte wird das Isolationsmaterial 16 in die Kavitäten 10 auf der zweiten Seitenfläche 12 eingezogen, so dass nach Beendigung dieses Schritts jede Kavität 10 auf der zweiten Seitenfläche 12 zumindest teilweise, bevorzugt vollständig, mit Isolationsmaterial 16 gefüllt ist.

Figur 4 zeigt eine alternative Möglichkeit für den in Figur 3 gezeigten Verfahrensschritt des Befüllens der Kavitäten 10 mit Isolationsmaterial 16 unter Nutzung der Kapillarkräfte. Bei dem in Figur 4 gezeigten Ausführungsbeispiel wird der Körper 1 mit der dritten Seitenfläche 6 in ein mit Isolationsmaterial 16 gefülltes Becken eingetaucht. Aufgrund der Kapillarkräfte steigt das Isolationsmaterial 16 entlang der Kavitäten 10 auf und befüllt diese dabei zumindest teilweise.

Der Vorteil dieses alternativen Ausführungsbeispiels besteht darin, dass es ermöglicht die erste und die zweite Seitenfläche 11, 12 in einem einzigen Verfahrensschritt mit Isolationsmaterial 16 zu befüllen. Allerdings erfordert der in Figur 4 gezeigte Prozessschritt eine längere Zeit zur Befüllung der Kavitäten 10, da das Isolationsmaterial 16 über eine größere Strecke hinweg durch die Kapillarkräfte bewegt werden muss. Daher kann das in Figur 3 gezeigte Ausführungsbeispiel des Verfahrens schneller durchgeführt werden, auch wenn die erste und die zweite Seitenfläche 11, 12 hierbei getrennt voneinander behandelt werden.

Nach dem Befüllen der Kavität 10 mit Isolationsmaterial 16 wird das Isoliermaterial 16 geliert, beispielsweise bei einer Temperatur zwischen 80 °C und 120 °C, vorzugsweise bei 100 °C, für eine Zeit zwischen 10 Minuten und 20 Minuten, vorzugsweise für 15 Minuten. Durch das Gelieren wird die Bildung von Blasen vermieden. Anschließend wird das Isoliermaterial 16 ausgehärtet, beispielsweise bei einer Temperatur zwischen 120 °C und 180 °C, vorzugsweise bei 150 °C, für eine Zeit zwischen 30 Minuten und 120 Minuten, vorzugsweise für 60 Minuten.

Nachdem die Kavitäten 10 mit Isoliermaterial 16 befüllt wurden und gegebenenfalls weitere Schritt wie Gelieren und Aushärten des Isoliermaterials 16 durchgeführt wurden, wird der Körper 1 entlang der Trennlinien T in Grundkörper 2 vereinzelt. In einem weiteren Verfahrensschritt wird nunmehr eine Passivierungsschicht 17 auf den Seitenflächen des Grundkörpers 2 aufgebracht, die nicht von einer Außenkontaktierung 13 bedeckt sind. Die Passivierungsschicht 17 ist ein Silikonelastomer, das einen anorganischen Füllstoff aufweist.

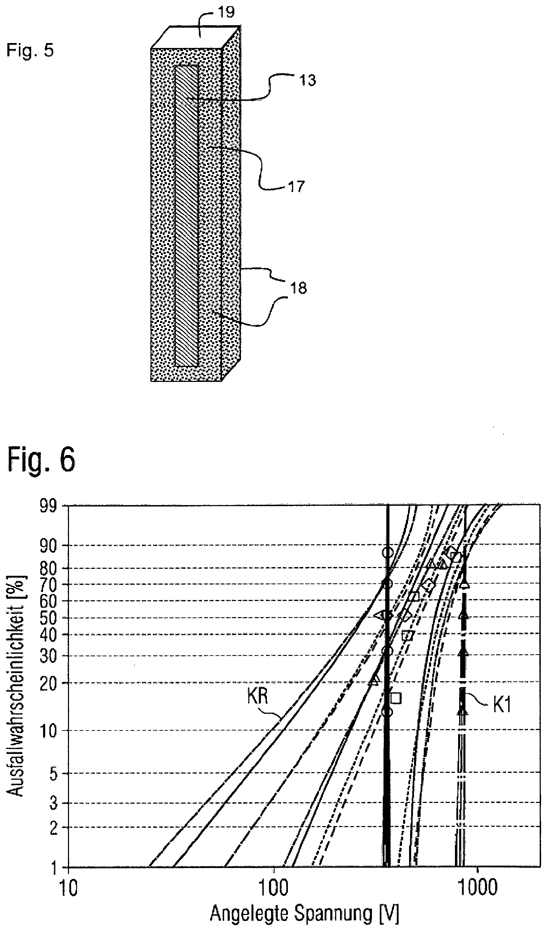

Es ergibt sich dann das in Figur 5 gezeigt Vielschichtbauelement. Wie in Figur 5 gezeigt, sind die aktiven Seitenflächen 18 des Vielschichtbauelements in den Bereichen, die nicht von der Außenkontaktierung 13 bedeckt sind, von der Passivierungsschicht 17 bedeckt. Die Stirnseiten 18 des Vielschichtbauelements bleiben frei von der Passivierung. Als aktive Seitenflächen 18 werden die Seitenflächen bezeichnet, deren Ausdehnung bei Betrieb des Vielschichtbauelements als Piezoaktor ändert. Diese Seitenflächen 18 weisen jeweils Flächennormale auf, die senkrecht zur Stapelrichtung S sind. Als Stirnseite 19 werden die Seitenflächen des Vielschichtbauelements bezeichnet, deren Ausdehnung bei Betrieb des Vielschichtbauelements als Piezoaktor im Wesentlich unverändert bleibt. Diese Stirnseiten 19 weisen jeweils Flächennormale auf, die in Stapelrichtung S zeigen.

Figur 6 zeigt ein Diagramm, in dem die Ausfallwahrscheinlichkeit in Folge von Durchbrüchen für Vielschichtbauelemente mit verschiedenen Materialkombinationen für das Isolationsmaterial 16 und das Material der Passivierungsschicht 17 betrachtet wird. Auf der Abszissenachse ist hierbei die an das Vielschichtbauelement angelegte Spannung in logarithmischer Darstellung aufgetragen. Auf der Ordinatenachse ist die Ausfallwahrscheinlichkeit in Prozent angegeben, die angibt, welcher Anteil der untersuchten Vielschichtbauelemente mit der jeweiligen Materialkombination bei der jeweils angelegten Spannung aufgrund von Durchschlägen ausfällt. Diese Größe ist ebenfalls in logarithmischer Darstellung aufgetragen.

Die Kurve K1 beschreibt die Ausfallwahrscheinlichkeit für ein bevorzugtes Ausführungsbeispiel des Vielschichtbauelements, bei dem als Isoliermaterial 16 ein Silikonelastomer, der frei von anorganischen Füllstoffen ist und als Material der Passivierungsschicht 17 ein Silikonelastomer, der zu 50 Gewichts-% mit Siliziumoxid als Füllstoff versetzt ist, aufgetragen ist.

Die Kurve KR beschreibt ein Referenzbeispiel, bei dem das gleiche Material für das Isolationsmaterial 16 und als Material der Passivierungsschicht 17 verwendet wird. Hierbei wurde jeweils ein Silikonelastomer, das frei von anorganischen Füllstoffen ist, verwendet. Figur 6 zeigt deutlich, dass es bei dem bevorzugten Ausführungsbeispiel erst bei wesentlich höheren angelegten Spannungen zu Ausfällen aufgrund von Durchschlägen kommt.

Das hier beschriebene Verfahren ermöglicht es, für die Passivierungsschicht 17 ein anderes Material als für das Isolationsmaterial 16 zu verwenden. Um die Kapillarkräfte zur Befüllung der Kavität 10 nutzen zu können, muss das Isolationsmaterial 16 dünnflüssig sein, d.h. es muss eine hohe Fließfähigkeit aufweisen. Da das beschriebene Verfahren es erlaubt ein anderes Material für die Passivierungsschicht 17 zu verwenden, gilt diese Einschränkung für die Passivierungsschicht 17 nicht. Dementsprechend kann das Material der Passivierungsschicht 17 so gewählt werden, dass es eine hohe elektrische Durchschlagsfestigkeit aufweist und so das Vielschichtbauelement besser gegen Beschädigungen durch Durchschläge schützen kann. Ferner kann das Material der Passivierungsschicht 17 auch auf Schutz gegen mechanische Beschädigungen hin optimiert werden.

### Bezugszeichenliste

- 1: Körper
- 2: Grundkörper
- 3: dielektrische Schicht
- 4: erste leitfähige Schicht
- 5: zweite leitfähige Schicht
- 6: dritte Seitenfläche
- 7: erste Hilfselektrode
- 8: vierte Seitenfläche
- 10: Kavität
- 11: erste Seitenfläche
- 12: zweite Seitenfläche
- 13: Außenkontaktierung
- 15: Spalt
- 15a: erster Spalt
- 15b: zweiter Spalt
- 16: Isolationsmaterial
- 17: Passivierungsschicht
- 18: aktive Seitenfläche
- 19: Stirnseite

- S: Stapelrichtung
- R: Richtung senkrecht zur Stapelrichtung S
- T: Trennlinien

## Patentansprüche

1. Verfahren zur Herstellung von Vielschichtbauelementen, aufweisend die Schritte:
A) Herstellung eines Körpers (1), der übereinander gestapelte elektrisch leitfähige Schichten (4, 5) und dielektrische Schichten (3) aufweist, wobei der Körper (1) zumindest eine Kavität (10) aufweist,
B) zumindest teilweises Befüllen der Kavität (10) mit einem Isolationsmaterial (16) unter Nutzung von Kapillarkräften,
C) Vereinzelung des Körpers (1) in zumindest zwei Grundkörper (2), wobei der Schritt C) nach dem Schritt B) erfolgt, und
D) Aufbringen einer Passivierungsschicht (17) auf Oberflächen der vereinzelten Grundkörper (2),
**dadurch gekennzeichnet, dass** die Passivierungsschicht (17) ein von dem Isolationsmaterial (16) verschiedenes Material aufweist.

2. Verfahren gemäß Anspruch 1,
wobei vor Schritt B) auf dem Körper (1) auf einer erste Seitenfläche (11) und einer zweiten Seitenfläche (12) für jeden Grundkörper (2) je eine Außenkontaktierung (13) aufgebracht werden, die die Kavität (10) teilweise bedeckt und die sich in Stapelrichtung erstreckt.

3. Verfahren gemäß Anspruch 2,
wobei zwischen zwei nebeneinander angeordneten Außenkontaktierungen (13) jeweils ein Spalt (15, 15a, 15b) verbleibt, und
wobei in Schritt B) in einer Stapelrichtung (S) auf jedem zweiten Spalt (15a) Isolationsmaterial (16) aufgebracht wird.

4. Verfahren gemäß einem der vorherigen Ansprüche,
wobei das Isolationsmaterial (16) ein Silikonelastomer ist, das frei von Füllstoffen ist.

5. Verfahren gemäß einem der vorherigen Ansprüche,
wobei die Passivierungsschicht (17) ein Silikonelastomer aufweist, das einen anorganischen Füllstoff aufweist.

6. Verfahren gemäß einem der vorherigen Ansprüche,
wobei die Kavität (10) an eine elektrisch leitfähige Schicht (4, 5) angrenzt und ein Ende der elektrisch leitfähigen Schicht (4, 5) bedeckt.

7. Vielschichtbauelement,
aufweisend einen Grundkörper (2) mit übereinander angeordnete elektrisch leitfähige Schichten (4, 5) und dielektrische Schichten (3),
wobei der Grundkörper (2) eine Kavität (10) aufweist, die zumindest teilweise mit einem Isolationsmaterial (16) befüllt ist, und
wobei das Vielschichtbauelement eine Passivierungsschicht (17) aufweist, die den Grundkörper (2) zumindest teilweise bedeckt **dadurch gekennzeichnet, dass** die Passivierungsschicht ein von dem Isolationsmaterial (16) verschiedenes Material aufweist.

8. Vielschichtbauelement gemäß Anspruch 7,
das ferner eine Außenkontaktierung (13) aufweist, die auf einer Seitenfläche (11, 12) des Grundkörpers (2) angeordnet ist, wobei das Isolationsmaterial (16) zwischen der elektrisch leitfähigen Schicht (4, 5) und der Außenkontaktierung (13) angeordnet ist, und
wobei die Passivierungsschicht (17) Oberflächen des Grundkörpers (2) bedeckt, die frei von der Außenkontaktierung (13) sind.

9. Vielschichtbauelement gemäß Anspruch 7 oder 8,
wobei die Passivierungsschicht (17) ein Silikonelastomer aufweist, das einen anorganischen Füllstoff aufweist.

10. Vielschichtbauelement gemäß einem der Ansprüche 7 bis 9,
wobei das Isolationsmaterial (16) ein Silikonelastomer ist, der frei von Füllstoffen ist.

## Claims

1. A method for manufacturing multilayer components, having the steps of:
A) manufacturing a body (1) which has electrically conductive layers (4, 5) and dielectric layers (3) which are stacked one above the other, wherein the body (1) has at least one cavity (10),
B) at least partially filling the cavity (10) with an insulation material (16) using capillary forces,
C) separating the body (1) into at least two base bodies (2), wherein step C) is effected after step B), and
D) applying a passivation layer (17) to surfaces of the separated base bodies (2), **characterised in that** the passivation layer (17) has a material which is different from the insulation material (16).

2. The method according to Claim 1,
wherein prior to step B), an outer contact (13) is applied in each case to a first side face (11) and a second side face (12) for each base body (2) on the body (1), the outer contact partially covering the cavity (10) and extending in a stacking direction.

3. The method according to Claim 2,
wherein a gap (15, 15a, 15b) remains in each case between two outer contacts (13) arranged next to one another, and wherein insulation material (16) is applied to each second gap (15a) in a stacking direction (S) in step B).

4. The method according to any one of the preceding claims,
wherein the insulation material (16) is a silicone elastomer which is free of fillers.

5. The method according to any one of the preceding claims,
wherein the passivation layer (17) has a silicone elastomer which has an inorganic filler.

6. The method according to any one of the preceding claims,
wherein the cavity (10) is adjacent to an electrically conductive layer (4, 5) and covers one end of the electrically conductive layer (4, 5).

7. A multilayer component, having a base body (2) with electrically conductive layers (4, 5) and dielectric layers (3) arranged one above the other,
wherein the base body (2) has a cavity (10) which is at least partially filled with an insulation material (16), and
wherein the multilayer component has a passivation layer (17) which at least partially covers the base body (2),
**characterised in that** the passivation layer has a material which is different from the insulation material (16).

8. The multilayer component according to Claim 7,
which further has an outer contact (13) which is arranged on a side face (11, 12) of the base body (2), wherein the insulation material (16) is arranged between the electrically conductive layer (4, 5) and the outer contact (13), and
wherein the passivation layer (17) covers surfaces of the base body (2) which are free of the outer contact (13).

9. The multilayer component according to Claim 7 or 8,
wherein the passivation layer (17) has a silicone elastomer which has an inorganic filler.

10. The multilayer component according to any one of Claims 7 to 9,
wherein the insulation material (16) is a silicone elastomer which is free of fillers.

## Revendications

1. Procédé pour la fabrication de composants multicouches, présentant les étapes :
A) fabrication d'un corps (1), qui présente des couches électriquement conductrices (4, 5) et des couches diélectriques (3) empilées les unes sur les autres, le corps (1) présentant au moins une cavité (10),
B) remplissage au moins partiel de la cavité (10) par un matériau d'isolation (16) à l'aide de forces capillaires,
C) séparation du corps (1) en au moins deux corps de base (2), l'étape C) ayant lieu après l'étape B) et
D) application d'une couche de passivation (17) sur des surfaces des corps de base (2) séparés,
**caractérisé en ce que** la couche de passivation (17) présente un matériau qui est différent du matériau d'isolation (16).

2. Procédé selon la revendication 1,
un connecteur externe (13) respectif, qui recouvre partiellement la cavité (10) et qui s'étend dans la direction de l'empilement, étant appliqué pour chaque corps de base (2), avant l'étape B), sur le corps (1) sur une première face latérale (11) et sur une deuxième face latérale (12).

3. Procédé selon la revendication 2,
une fente (15, 15a, 15b) restant à chaque fois entre deux connecteurs externes (13) disposés l'un à côté de l'autre et du matériau d'isolation (16) étant appliqué dans l'étape B) sur chaque deuxième fente (15a) dans un sens d'empilement (S) .

4. Procédé selon l'une quelconque des revendications précédentes,
le matériau d'isolation (16) étant un élastomère de silicone qui est exempt de charges.

5. Procédé selon l'une quelconque des revendications précédentes,
la couche de passivation (17) présentant un élastomère de silicone qui présente une charge inorganique.

6. Procédé selon l'une quelconque des revendications précédentes,
la cavité (10) étant adjacente à une couche électriquement conductrice (4, 5) et recouvrant une extrémité de la couche électriquement conductrice (4, 5).

7. Composant multicouche,
présentant un corps de base (2) présentant des couches électriquement conductrices (4, 5) et des couches diélectriques (3) disposées les unes sur les autres,
le corps de base (2) présentant une cavité (10) qui est remplie au moins partiellement par un matériau d'isolation (16) et
le composant multicouche présentant une couche de passivation (17) qui recouvre au moins partiellement le corps de base (2),
**caractérisé en ce que** la couche de passivation présente un matériau différent de celui du matériau d'isolation (16).

8. Composant multicouche selon la revendication 7,
qui présente en outre un connecteur externe (13) qui est disposé sur une face latérale (11, 12) du corps de base (2), le matériau d'isolation (16) étant disposé entre la couche électriquement conductrice (4, 5) et le connecteur externe (13) et
la couche de passivation (17) recouvrant des surfaces du corps de base (2) qui sont exemptes du connecteur externe (13) .

9. Composant multicouche selon la revendication 7 ou 8,
la couche de passivation (17) présentant un élastomère de silicone qui présente une charge inorganique.

10. Composant multicouche selon l'une quelconque des revendications 7 à 9,
le matériau d'isolation (16) étant un élastomère de silicone qui est exempt de charges.
